(19) Europäisches Patentamt
European Patent Office
Office européen des brevets

(11) Publication number: **0 442 568 B1**

(12) **EUROPEAN PATENT SPECIFICATION**

(45) Date of publication of patent specification: **06.12.95**

(51) Int. Cl.[6]: **C08G 59/68**, C08G 59/62, C08G 59/24, C08L 63/00, H01L 23/29, C08K 5/00

(21) Application number: **91200269.8**

(22) Date of filing: **08.02.91**

# (54) Epoxy resin compositions for encapsulating semiconductive elements.

(30) Priority: **16.02.90 JP 33704/90**

(43) Date of publication of application: **21.08.91 Bulletin 91/34**

(45) Publication of the grant of the patent: **06.12.95 Bulletin 95/49**

(84) Designated Contracting States: **BE CH DE ES FR GB IT LI NL**

(56) References cited:
**EP-A- 0 041 662**
**US-A- 4 105 634**

**DATABASE WPIL, AN=91-070517 [10], Derwent Publications Ltd, London, GB**

(73) Proprietor: **SHELL INTERNATIONALE RESEARCH MAATSCHAPPIJ B.V.**
**Carel van Bylandtlaan 30**
**NL-2596 HR Den Haag (NL)**

(72) Inventor: **Murata, Yasukuki, Yuka Shell Epoxy K K, Nishiazabu**
**Mitsui Bdg,**
**17-30 Nishiazabu 4-chome**
**Minato-ku,**
**Tokyo 106 (JP)**
Inventor: **Konishi, Isako, Yuka Shell Epoxy K K, Nishiazabu**
**Mitsui Bdg,**
**17-30 Nishiazabu 4-chome**
**Minato-ku,**
**Tokyo 106 (JP)**
Inventor: **Nakanishi, Yoshinoi, Yuka Shell Epoxy K K**
**Nishiazabu Mitsui Bdg,**
**17-30 Nishiazabu 4-chome**
**Minato-ku,**
**Tokyo 106 (JP)**
Inventor: **Kurio, Takuya, Yuka Shell Epoxy K K, Nishiazabu**
**Mitsui Bdg,**
**17-30 Nishiazabu 4-chome**
**Minato-ku,**
**Tokyo 106 (JP)**

**EP 0 442 568 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to epoxy resin compositions for encapsulating semiconductive elements showing when cured a high glass transition temperature, an excellent crack resistance under soldering and a low chlorine ion generation rate upon curing, thus providing a cured product having excellent qualities, including moisture resistance.

In recent years, high integration technology has made a remarkable advance, in particular with respect to the enlargement of the size of semiconductive elements while simultaneously miniaturizing and thinning the packages themselves. Furthermore surface application of semiconductive elements is becoming more usual. In surface application, the semiconductive device is directly immersed in bath of molten solder and exposed to high temperature. However, in this process the encapsulating material may absorb water which causes the formation of cracks in the encapsulating material.

A formulation of ortho cresol novolak-type epoxy resin with phenol novolak resin as curing agent, and triphenylphosphine as curing accelerator is normally used as epoxy resin composition for encapsulating semiconductive elements. However, it is known that such compositions when used as encapsulating material, show insufficient crack resistance under soldering due to its low glass transition temperature.

Another problem encountered in the course of miniaturization using standard type of epoxy resin compositions is the corrosion of aluminium wirings. This corrosion is known to be caused by moisture absorbed in packages and the presence of chlorine ions as contaminant in such packages.

The use of triphenyl-phosphine (TPP) as curing accelerator in the epoxy resin composition results in a cured product showing a good moisture resistance due to the small degree of chlorine ion generation upon curing. However, the cured product also has a low glass transition temperature and a poor crack resistance under soldering due to the relatively low activity of TPP.

When using a curing accelerator having a stronger activity such as an imidazole a cured product having a higher glass transition temperature is indeed obtained, however, the degree of chlorine ion generation increases substantially too.

In search of solutions to the problems related to the use of ortho cresol novolak-type epoxy resin in the encapsulating compositions bishydroxybiphenyl-type epoxy resin was found to be an excellent epoxy resin for encapsulating semiconductive elements due to its low stress and low viscosity. However, since its glass transition temperature is far lower than that of the o-cresol novolak-type epoxy resin, the use of a highly active accelerator is essential. But as pointed out before, the use of such a known highly active accelerator will affect the moisture resistance of the cured product due to the large amounts of chlorine ions formed upon curing.

Therefore it is an object of the present invention to provide an epoxy resin composition for encapsulating semiconductive elements which when cured shows a high glass transition temperature, an excellent crack resistance under soldering and an excellent moisture resistance.

A solution to the above-mentioned technological problem was found in using a specific type of tris-(dialkoxyphenyl) phosphines as curing accelerators.

The invention therefore relates to an epoxy resin composition for encapsulating semiconductive elements comprising

(a) epoxy resin,
(b) phenolic curing agent,
(c) tris(dialkoxyphenyl) phosphine represented by the general formula (I):

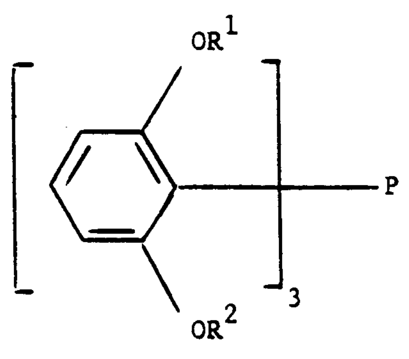

(I)

wherein $R^1$ and $R^2$ each independently represent a $C_{1-4}$ alkyl group, and
(d) inorganic filler.

It was found that the epoxy resin composition of the invention, when cured, has a high glass transition temperature and that during curing only a relatively small amount of chlorine ions are generated. Moreover when a specific bishydroxybiphenyl-type of epoxy resin is used in (a), the cured product shows a sufficiently high glass transition temperature while maintaining the excellent properties of the epoxy resin.

As epoxy resin under (a) use may be made of various kinds of epoxy resins. As examples may be mentioned those prepared by reacting epihalohydrin with polyhydric phenols, being condensation products of phenols such as bisphenol A, bisphenol F, hydroxybiphenyls, resorcine, hydroquinone, methylresorcine, phenol novolak, cresol novolak, resorcine novolak, and bisphenol A novolak, and aldehydes such as benzaldehyde, hydroxybenzaldehyde and glyoxal.

Preferably the composition according to the invention comprises from 20 to 100% by weight, based on the weight of epoxy resin in the composition, of bishydroxybiphenyl epoxy resin represented by the general formula (II):

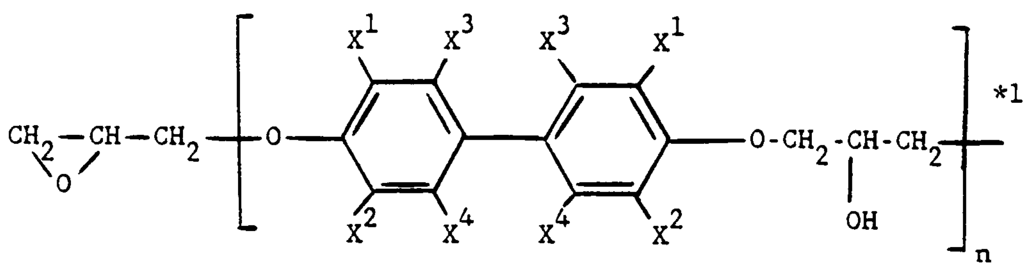

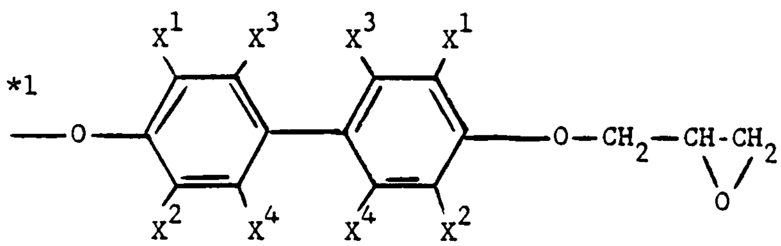

(II)

wherein $X^1$ to $X^4$ each may represent a hydrogen atom, a halogen atom or a $C_{1-5}$ alkyl group, and n is a number of from 0 to 3.

It should be noted that the epoxy resin represented by the above-mentioned general formula (II), may of course be the only epoxy resin present in the composition.

The bishydroxybiphenyl-type epoxy resin represented by the above-mentioned general formula (II) can be easily prepared by reacting bishydroxybiphenyls represented by the general formula (III):

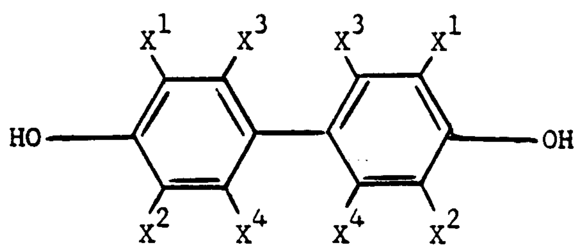

(III)

wherein $X^1$ to $X^4$ each may represent a hydrogen atom, a halogen atom or a $C_{1-5}$ alkyl group, with an excessive amount of epihalohydrin, according to any conventional method.

As bishydroxybiphenyls of formula (III) to be employed in the process of this invention may be mentioned, for example, 4,4'-bishydroxybiphenyl, 4,4'-bishydroxy-3,3',5,5'-tetramethylbiphenyl, 4,4'-bishydroxy-3,3',5,5'-tetramethyl-2-chlorobiphenyl, 4,4'-bishydroxy-3,3',5,5'-tetramethyl-2-bromobiphenyl and 4,4'-bishydroxy-3,3',5,5'-tetraethylbiphenyl.

The epoxy resin composition according to the present invention comprises a phenolic curing agent. Preferred phenolic curing agents should comprise at least two phenolic hydroxyl groups per molecule.

Examples of the phenolic curing agent are the condensation products of phenols such as phenol novolak, cresol novolak, resorcine novolak, and bisphenol A novolak, with aldehydes such as benzaldehyde, hydroxybenzaldehyde and glyoxal. The phenolic curing agent(s) employed in the present invention preferably is/are used in amounts ranging of from 20 to 200 parts by weight per 100 parts by weight of the epoxy resin. Preferably the amount of phenolic curing agent in the composition of the invention is such that of from 0.5 to 2.0 hydroxyl groups, preferably 1 hydroxyl group are/is present per epoxy group.

The epoxy resin composition according to the present invention also comprises a tris(dialkoxyphenyl) phosphine represented by the above-mentioned general formula (I) as curing accelerator. Examples of such curing accelerators are tris(dimethoxyphenyl) phosphine and tris(diethoxyphenyl) phosphine.

The tris(dialkoxyphenyl) phosphine (I) may be used alone or in combination with one or more other curing accelerators so far as the latter does not adversely affect the effect of the former. Other curing accelerators are for example, tertiary amines such as 2-(dimethylaminomethyl) phenol, 2,4,6-tris-(dimethylaminomethyl) phenol, benzyldimethylamine, α-methylbenzyldimethylamine, imidazoles such as 2-methylimidazole, 2-phenylimidazole, 2-undecylimidazole, 2-heptadecylimidazole, 2-ethyl-4-methylimidazole and phosphines such as triphenylphosphine.

When use is made of a combination of accelerators the amount of tris(dialkoxyphenyl) phosphine (I) should be from 20 to 100% by weight, preferably at least 40% by weight, based on the total weight of accelerators in the composition.

The total amount of accelerators in the epoxy resin compositions of the present invention preferably lies in the range of from 0.1 to 5% by weight based on the weight of epoxy resin.

The epoxy resin compositions of the present invention should also comprise an inorganic filler. Any inorganic filler usually formulated into epoxy resins can be used such as for example, fused silica, crystalline silica, quartz glass powder, talc, calcium silicate powder, zirconium silicate powder, alumina powder, calcium carbonate powder, clay powder, barium sulphate powder and glass fibres. Combinations of these inorganic fillers may also be used. A preferred filler is silica.

The amount of inorganic filler present in the composition of the invention must be sufficient to impart the desired modulus of elasticity, linear expansion coefficient and glass transition point to the cured product thereof. The amount of inorganic filler used usually lies in the range of from 50 to 90% by weight based on the total weight of the composition of the invention. If less than 50% by weight of filler is added this will have a negative effect on the linear expansion coefficient of the cured products, whereas if more than 90% by weight of filler is added the fluidity of the resin compositions will be degraded, resulting in poor handle-ability.

If required the epoxy resin compositions of the present invention may comprise mould releasing agents, colourants, coupling agents and fire retardants. As mould releasing agents can be mentioned natural wax, synthetic wax, higher fatty acids, metal salts of higher fatty acids and paraffins.

A useful colourant is for example carbon black. Useful fire retardants are for instance antimony trioxide, antimony bentoxide, phosphoric acid and phosphorus compounds. Part of the amount of epoxy resin may be replaced by brominated epoxy resin in order to impart fire resistancy to the composition. Examples of such brominated epoxy resins are brominated bispenol A-type epoxy resins and brominated phenol novolak-type epoxy resins.

The epoxy resin composition according to the present invention can be prepared usually by mixing, under heat-melting, the above-mentioned essential components (a) to (d), if necessary, with other additive components, the order of mixing of these components is optional.

The present invention will be further explained in the examples presented below.

Example 1, Production of Epoxy Resins 1 and 2

A. In a reactor equipped with a stirrer, a thermometer, and a condenser were mixed 242 g of 3,3',5,5'-tetramethyl-4,4'-dihydroxybiphenyl, 1295 g of epichlorohydrin, and 504 g of isopropyl alcohol to form a solution. Then, the resulting solution was heated to 35 °C, followed by dropwise application, for one hour, of 190 g of an aqueous solution of sodium hydroxide (48.5% by weight). During the above-mentioned dropwise application, the temperature of the solution was gradually raised until the reaction system reached 65 °C at the point of completion of the dropwise application. Thereafter, the reaction was carried out at 65 °C for 30 minutes.

After completion of the reaction, the reaction product was washed with water to remove the byproduct salts such as sodium hydroxide. Excessive epichlorohydrin and isopropyl alcohol were

removed from the reaction product under vaporization at reduced pressure, and the crude epoxy compound was recovered. This crude epoxy compound was dissolved in 596 g of toluene, followed by the addition of 12.9 g of an aqueous solution of sodium hydroxide (48.5% by weight) whereafter the mixture was allowed to react for one hour at 65 °C. After completion of the reaction sodium diH-orthophosphate was added to the reaction system so as to neutralize the excess of sodium hydroxide, followed by waterwashing thereof for removing the byproduct salts therefrom.

Under reduced pressure remaining solvent was completely removed from the epoxy compound obtained in the above example. This epoxy compound was found to have the general formula (II) wherein $X^1$ and $X^2$ each are a methyl group, $X^3$ and $X^4$ each are a hydrogen atom, and n is 1, and having an epoxy equivalent weight of 185. This compound will be referred to as "Epoxy Resin 1" hereinafter.

B. An epoxy resin in the form of light yellow solid having an epoxy equivalent weight of 164 was prepared according to the same method as used for the preparation of Epoxy Resin 1, however instead of 4,4'-bishydroxy-3,3',5,5'-tetramethylbiphenyl employed in the above-mentioned example 1A, use was made of 186 g of 4,4'-bishydroxybiphenyl.

This epoxy resin had the above-mentioned general formula (I) wherein $X^1$, $X^2$, $X^3$ and $X^4$ each are hydrogen atom and n is 0.15, which will be referred to as "Epoxy Resin 2" hereinafter.

Example 2, runs 1-3 and comparative runs 4-6

In runs 1-6 a plurality of compositions were formulated comprising the epoxy resins that had been obtained in the above-mentioned production examples or a commercially available ortho-cresol novolak-type epoxy resin and, as fire-retardative epoxy resin, brominated bisphenol A-type epoxy resin, together with a phenol novolak resin as curing agent, tris(2,6-dimethoxyphenyl) phosphine or triphenylphosphine or 2-phenylimidazole as curing accelerator, and as inorganic fillers, silica powder and epoxy silane. Compositions comprising the varying components in varying ratios as shown in Table 1 were molten and mixed at a temperature in the range of from 90 to 110 °C for five minutes using a mixing roll. The resulting molten mixture was taken out in the form of a sheet and was then cooled and crushed to obtain a moulding material.

Each of the formed moulding materials was then moulded using a low pressure transfer moulding machine at a temperature of 180 °C during 180 sec, in order to form a test piece for measurements of glass transition point and chlorine ion generation rate, also 44 pin flat plastic packages with dummy elements being encapsulated therein were formed of each of the compositions. After the heat-curing for 8 hours at 180 °C, glass transition point, thermal resistance under soldering and chlorine ion generation rate were determined on each of the moulded products, the results of which are shown in Table 1.

TABLE 1

| Run | Invention runs 1 | 2 | 3 | Comparative runs 4 | 5 | 6 |
|---|---|---|---|---|---|---|
| **Formulated compositions (part by weight)** | | | | | | |
| Epoxy Resin 1 *1 | 100 | - | - | 100 | 100 | - |
| Epoxy Resin 2 *2 | - | 100 | - | - | - | - |
| O-cresol novolak-type epoxy resin *3 | - | - | 100 | - | - | 100 |
| Brominated bisphenol A-type epoxy resin *4 | 10 | 10 | 10 | 10 | 10 | 10 |
| Phenol novolak resin *5 | 58 | 65 | 54 | 58 | 58 | 54 |
| Tris(2,6-dimethoxyphenyl)phosphine | 1.0 | 1.0 | 1.0 | - | - | - |
| Triphenyl phosphine | - | - | - | 1.0 | - | 1.0 |
| 2-phenylimidazole | - | - | - | - | 1.0 | - |
| Silica powder *6 | 392 | 408 | 383 | 392 | 392 | 383 |
| Antimony trioxide | 10 | 10 | 10 | 10 | 10 | 10 |
| Carnauba wax | 1.0 | 1.0 | 1.0 | 1.0 | 1.0 | 1.0 |
| Epoxy silane *7 | 1.0 | 1.0 | 1.0 | 1.0 | 1.0 | 1.0 |
| **Test Results** | | | | | | |
| Glass transition temperature (°C) *8 | 175 | 182 | 184 | 145 | 173 | 165 |
| Thermal resistance under soldering *9 | 0/16 | 0/16 | 1/16 | 11/16 | 2/16 | 14/16 |
| Chlorine ion generation rate (ppm) *10 | 2 | 4 | 2 | 2 | 15 | 3 |

Remarks:

*1 ... Epoxy Resin 1, prepared in Example 1A

*2 ... Epoxy Resin 2, prepared in Example 1B

*3 ... Tradename "Epikote 180H65" having an epoxy equivalent weight of 201, a product by Yuka Shell Epoxy K.K.

*4 ... Tradename "Epikote 5050", having an epoxy equivalent weight of 385 and a bromine content of 49%, a product by Yuka Shell Epoxy K.K.

*5 ... Phenol novolak having a softening point of 85 °C, a product by Gunei Chemical K.K.

*6 ... Tradename "RD-8", a product by Ryushinsha K.K.

*7 ... Tradename "KBM-403", a product by Shinetsu Chemical K.K.

*8 ... Determined from transition point in thermal expansion curve with the use of trimellitic anhydride (TMA).

*9 ... Determined on the number of cracks formed in sixteen pieces of flat plastic packages (44 pin FPP) which had been exposed to moisture at 85 °C and 85% RH for 168 hours, followed by being immersed in bath of molten solder at 260 °C for ten seconds.

*10 .. The cured moulded materials each were crushed to a particle size of 100 mesh-pass, 5 g of the material together with 50 g of distilled water was introduced into a pressure vessel followed by extraction therewith at 180 °C for 24 hours, and then the amount of generating chlorine ion in the water was determined.

From Table 1 it can be derived that the epoxy resin compositions for encapsulating semiconductive elements according to the present invention (runs 1-3) can provide a cured product having a combination of a high glass transition temperature, an excellent crack resistance under soldering and a low chlorine ion generation rate.

## Claims

### Claims for the following Contracting States : BE, CH, LI, DE, FR, GB, IT, NL

1. An epoxy resin composition for encapsulating semiconductive elements comprising
   (a) epoxy resin,
   (b) phenolic curing agent,

(c) tris(dialkoxyphenyl) phosphine represented by the general formula (I):

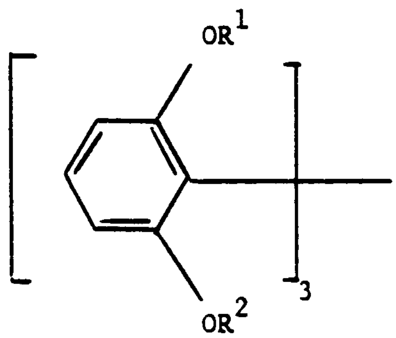

(I)

wherein $R^1$ and $R^2$ each independently represent a $C_{1-4}$ alkyl group, and
(d) inorganic filler.

2. An epoxy resin composition as claimed in claim 1, wherein from 20 to 100% by weight of the total amount of epoxy resin present in the composition consists of bishydroxybiphenyl-type epoxy resin represented by the general formula (II):

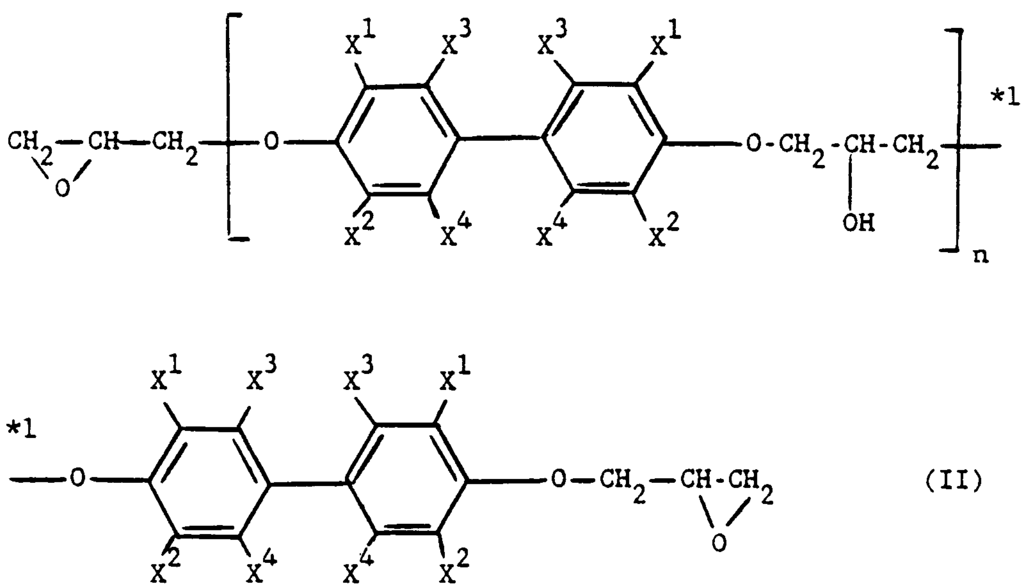

(II)

wherein $X^1$ to $X^4$ each may represent a hydrogen atom, a halogen atom or a $C_{1-5}$ alkyl group, and n is on average a value of from 0 to 3.

3. An epoxy resin composition as claimed in claim 1 or 2 wherein the phenolic curing agent is present in an amount of from 20 to 200 parts per weight (ppw) per 100 ppw of epoxy resin.

4. An epoxy resin composition as claimed in any one of the claims 1 to 3 comprising a combination of accelerators comprising 20% by weight or more, based on the total weight of accelerators in the composition, of (a) compound(s) of the general formula (I).

5. An epoxy resin composition as claimed in any one of the claims 1 to 4 wherein the total amount of accelerators in the composition ranges of from 0.1% to 5.0% by weight based on the weight of epoxy resin.

6. An epoxy resin composition as claimed in any one of the claims 1 to 4 wherein the total amount of filler in the composition ranges of from 50% to 90% by weight based on the total weight of the composition.

7. An epoxy resin composition as claimed in any one of the claims 1 to 6 comprising tris(2,6-dimethoxyphenyl) phosphine as accelerator.

**Claims for the following Contracting State : ES**

1. Process for the preparation of an epoxy resin composition for encapsulating semiconductive elements characterized in that the resin composition comprises:
   (a) epoxy resin,
   (b) phenolic curing agent,
   (c) tris(dialkoxyphenyl) phosphine represented by the general formula (I):

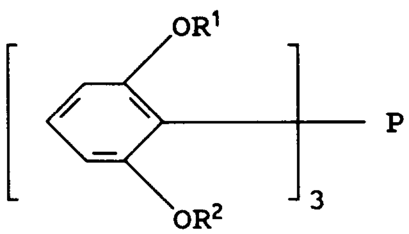

(I)

   wherein $R^1$ and $R^2$ each independently represent a $C_{1-4}$ alkyl group, and
   (d) inorganic filler.

2. A process as claimed in claim 1, wherein from 20 to 100% by weight of the total amount of epoxy resin present in the resin composition consists of bishydroxybiphenyl-type epoxy resin represented by the general formula (II):

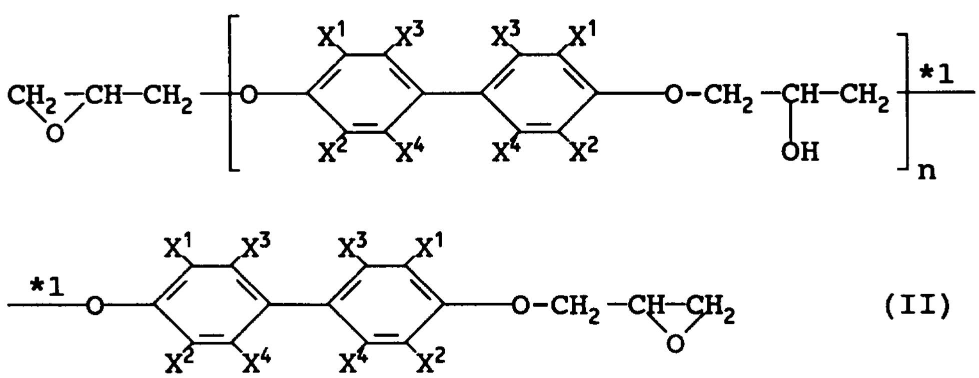

(II)

   wherein $X^1$ to $X^4$ each may represent a hydrogen atom, a halogen atom or a $C_{1-5}$ alkyl group, and n is on average a value of from 0 to 3.

3. A process as claimed in claim 1 or 2 wherein the phenolic curing agent is present in an amount of from 20 to 200 parts per weight (ppw) per 100 ppw of epoxy resin.

4. A process as claimed in any one of the claims 1 to 3 comprising a combination of accelerators comprising 20% by weight or more, based on the total weight of accelerators in the composition, of (a) compound(s) of the general formula (I).

5. A process as claimed in any one of the claims 1 to 4 wherein the total amount of accelerators in the composition ranges of from 0.1% to 5.0% by weight based on the weight of epoxy resin.

6. A process as claimed in any one of the claims 1 to 4 wherein the total amount of filler in the composition ranges of from 50% to 90% by weight based on the total weight of the composition.

7. A process as claimed in any one of the claims 1 to 6 comprising tris(2,6-dimethoxyphenyl) phosphine as accelerator.

**Patentansprüche**
**Patentansprüche für folgende Vertragsstaaten : BE, CH, LI, DE, FR, GB, IT, NL**

1. Epoxidharzzusammensetzung zum Einkapseln von Halbleiterelementen, enthaltend
(a) Epoxidharz,
(b) phenolisches Vernetzungsmittel,
(c) Tris(dialkoxyphenyl)phosphin, das durch die allgemeine Formel (I)

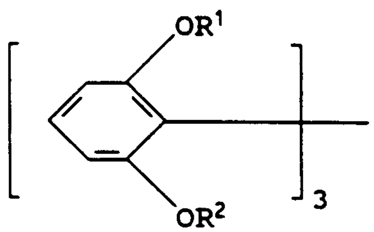

(I)

dargestellt wird, in der $R^1$ und $R^2$ jeweils unabhängig für eine $C_1$-$C_4$-Alkylgruppe stehen, und
(d) anorganischen Füllstoff.

2. Epoxidharzzusammensetzung nach Anspruch 1, wobei 20 bis 100 Gewichtsprozent der Gesamtmenge an in der Zusammensetzung vorliegendem Epoxidharz aus einem bishydroxybiphenylartigen Epoxidharz bestehen, das durch die allgemeine Formel (II)

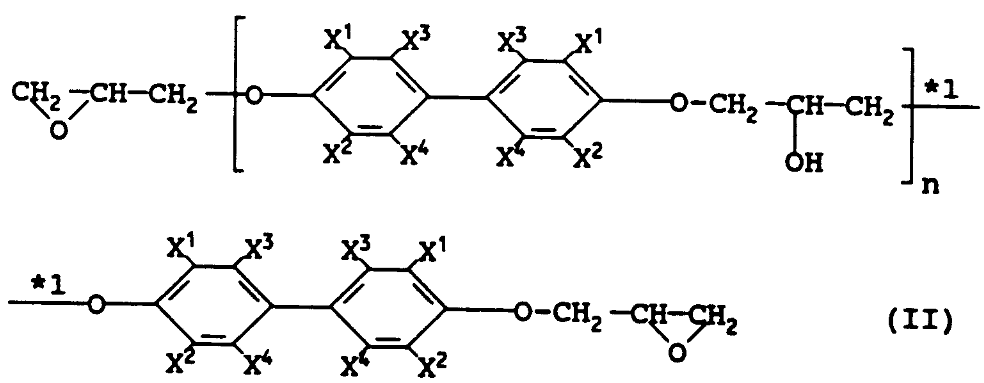

(II)

dargestellt wird, in der $X^1$ bis $X^4$ jeweils für ein Wasserstoffatom, ein Halogenatom oder eine $C_1$-$C_5$-Alkylgruppe stehen können und n im Durchschnitt einen Wert von 0 bis 3 hat.

3. Epoxidharzzusammensetzung nach Anspruch 1 oder 2, wobei das phenolische Vernetzungsmittel in einer Menge von 20 bis 200 Gewichtsteilen je 100 Gewichtsteile Epoxidharz vorliegt.

4. Epoxidharzzusammensetzung nach einem der Ansprüche 1 bis 3, welche eine Kombination von Beschleunigern enthält, die 20 Gew.-% oder mehr bezüglich des Gesamtgewichtes der in der Zusammensetzung vorliegenden Beschleuniger an (einer) Verbindung(en) der allgemeinen Formel (I) enthält.

5. Epoxidharzzusammensetzung nach einem der Ansprüche 1 bis 4, wobei die Gesamtmenge der in der Zusammensetzung vorliegenden Beschleuniger im Bereich von 0,1 Gew.-% bis 5,0 Gew.-% bezüglich

des Gewichtes an Epoxidharz liegt.

6. Epoxidharzzusammensetzung nach einem der Ansprüche 1 bis 4, wobei die Gesamtmenge des in der Zusammensetzung vorliegenden Füllstoffs im Bereich von 50 Gew.-% bis 90 Gew.-% bezüglich des Gesamtgewichtes der Zusammensetzung liegt.

7. Epoxidharzzusammensetzung nach einem der Ansprüche 1 bis 6, die als Beschleuniger Tris(2,6-dimethoxyphenyl)phosphin enthält.

**Patentansprüche für folgenden Vertragsstaat : ES**

1. Verfahren zur Herstellung einer Epoxidharzzusammensetzung zum Einkapseln von Halbleiterelementen, dadurch gekennzeichnet, daß die Harzzusammensetzung
   (a) Epoxidharz,
   (b) phenolisches Vernetzungsmittel,
   (c) Tris(dialkoxyphenyl)phosphin, das durch die allgemeine Formel (I)

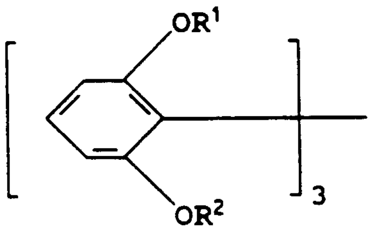

(I)

   dargestellt wird, in der $R^1$ und $R^2$ jeweils unabhängig für eine $C_1$-$C_4$-Alkylgruppe stehen, und
   (d) anorganischen Füllstoff

   enthält.

2. Verfahren nach Anspruch 1, wobei 20 bis 100 Gewichtsprozent der Gesamtmenge an in der Harzzusammensetzung vorliegendem Epoxidharz aus einem bishydroxybiphenyl-artigen Epoxidharz bestehen, das durch die allgemeine Formel (II)

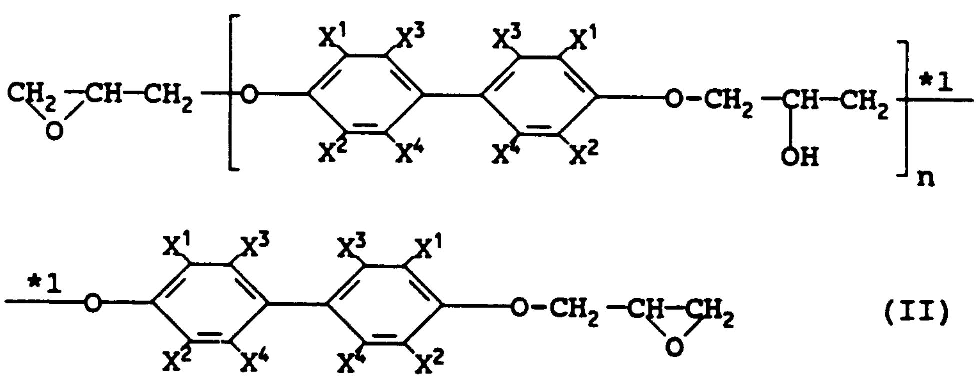

(II)

   dargestellt wird, in der $X^1$ bis $X^4$ jeweils für ein Wasserstoffatom, ein Halogenatom oder eine $C_1$-$C_5$-Alkylgruppe stehen können und n im Durchschnitt einen Wert von 0 bis 3 hat.

3. Verfahren nach Anspruch 1 oder 2, wobei das phenolische Vernetzungsmittel in einer Menge von 20 bis 200 Gewichtsteilen je 100 Gewichtsteile Epoxidharz vorliegt.

4. Verfahren nach einem der Ansprüche 1 bis 3, welches eine Kombination von Beschleunigern umfaßt, die 20 Gew.-% oder mehr bezüglich des Gesamtgewichtes der in der Zusammensetzung vorliegenden

Beschleuniger an (einer) Verbindung(en) der allgemeinen Formel (I) enthält.

5. Verfahren nach einem der Ansprüche 1 bis 4, wobei die Gesamtmenge der in der Zusammensetzung vorliegenden Beschleuniger im Bereich von 0,1 Gew.-% bis 5,0 Gew.-% bezüglich des Gewichtes an Epoxidharz liegt.

6. Verfahren nach einem der Ansprüche 1 bis 4, wobei die Gesamtmenge des in der Zusammensetzung vorliegenden Füllstoffs im Bereich von 50 Gew.-% bis 90 Gew.-% bezüglich des Gesamtgewichtes der Zusammensetzung liegt.

7. Verfahren nach einem der Ansprüche 1 bis 6, das Tris(2,6-dimethoxyphenyl)phosphin als Beschleuniger umfaßt.

**Revendications**
**Revendications pour les Etats contractants suivants : BE, CH, LI, DE, FR, GB, IT, NL**

1. Composition de résine époxy pour l'encapsulation d'éléments semi-conducteurs qui comprend :
   (a) une résine époxy;
   (b) un agent de durcissement phénolique;
   (c) une tris(dialcoxyphényl)phosphine représentée par la formule générale (I) ci-dessous :

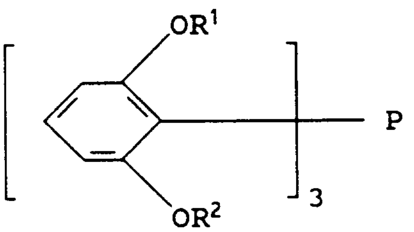

(I)

   dans laquelle les symboles $R^1$ et $R^2$ représentent chacun indépendamment un radical alkyle en $C_1$ à $C_4$, et
   (d) une charge inorganique.

2. Composition de résine époxy suivant la revendication 1, caractérisée en ce que de 20 à 100% en poids de la quantité totale de la résine époxy présente dans la composition sont constitués d'une résine époxy du type bishydroxybiphényle représentée par la formule générale (II) :

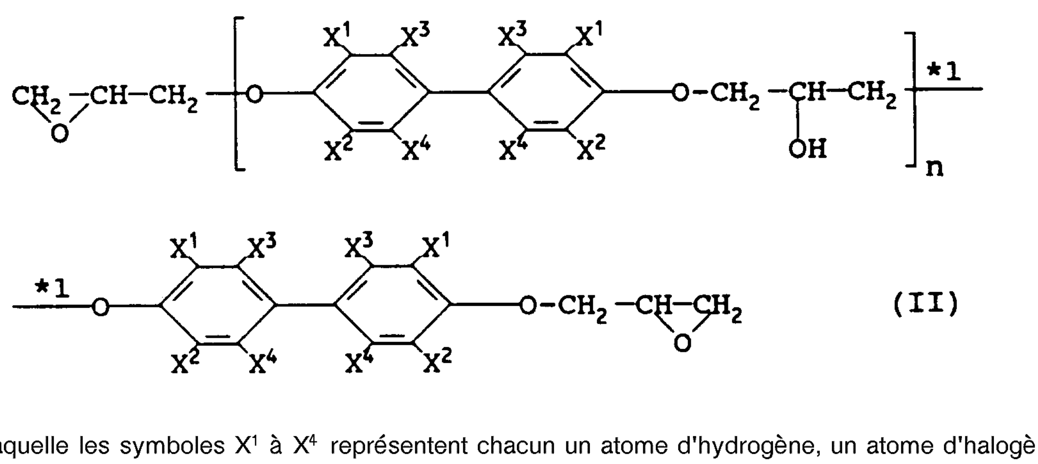

(II)

dans laquelle les symboles $X^1$ à $X^4$ représentent chacun un atome d'hydrogène, un atome d'halogène, ou un radical alkyle en $C_1$ à $C_5$, et n a, en moyenne, une valeur qui varie de 0 à 3.

3. Composition de résine époxy suivant la revendication 1 ou 2, caractérisée en ce que l'agent de durcissement phénolique est présent en une quantité de 20 à 200 parties en poids par 100 parties en

poids de résine époxy.

4. Composition de résine époxy suivant l'une quelconque des revendications 1 à 3, caractérisée en ce qu'elle comprend une combinaison d'accélérateurs comprenant 20% en poids ou plus, sur base du poids total des accélérateurs présents dans la composition, de composé(s) (a) de la formule générale (I).

5. Composition de résine époxy suivant l'une quelconque des revendications 1 à 4, caractérisée en ce que la quantité totale d'accélérateurs présente dans la composition varie de 0,1% à 5,0% en poids, sur base du poids de la résine époxy.

6. Composition de résine époxy suivant l'une quelconque des revendications 1 à 4, caractérisée en ce que la quantité totale de charge présente dans la composition varie de 50% à 90% en poids, sur base du poids total de la composition.

7. Composition de résine époxy suivant l'une quelconque des revendications 1 à 6, caractérisée en ce qu'elle comprend de la tris(2,6-diméthoxyphényl)phosphine à titre d'accélérateur.

**Revendications pour l'Etat contractant suivant : ES**

1. Procédé de préparation d'une composition de résine époxy pour l'encapsulation d'éléments semi-conducteurs, caractérisé en ce que la composition de résine comprend :
   (a) une résine époxy;
   (b) un agent de durcissement phénolique;
   (c) une tris(dialcoxyphényl)phosphine représentée par la formule générale (I) ci-dessous :

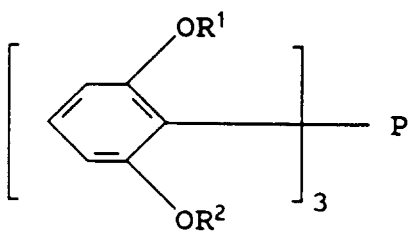

(I)

   dans laquelle les symboles $R^1$ et $R^2$ représentent chacun indépendamment un radical alkyle en $C_1$ à $C_4$, et
   (d) une charge inorganique.

2. Procédé suivant la revendication 1, caractérisé en ce que de 20 à 100% en poids de la quantité totale de la résine époxy présente dans la composition sont constitués d'une résine époxy du type bishydroxybiphényle représentée par la formule générale (II) :

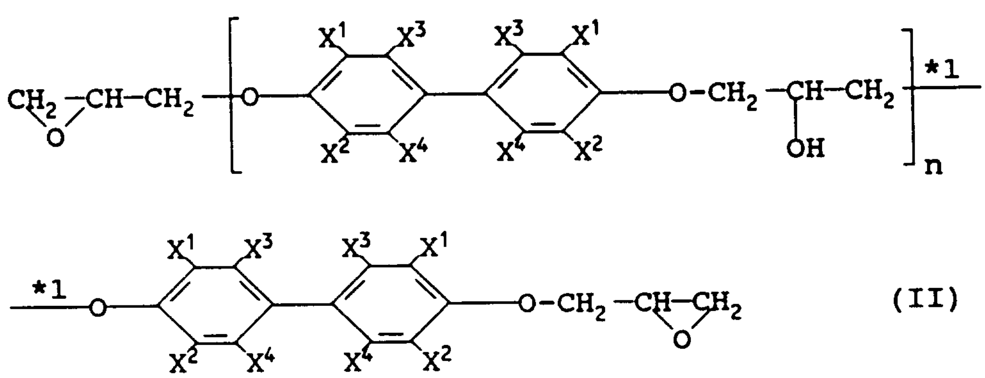

(II)

dans laquelle les symboles $X^1$ à $X^4$ représentent chacun un atome d'hydrogène, un atome d'halogène,

ou un radical alkyle en $C_1$ à $C_5$, et n a, en moyenne, une valeur qui varie de 0 à 3.

**3.** Procédé suivant la revendication 1 ou 2, caractérisé en ce que l'agent de durcissement phénolique est présent en une quantité de 20 à 200 parties en poids par 100 parties en poids de résine époxy.

**4.** Procédé suivant l'une quelconque des revendications 1 à 3, caractérisé en ce qu'il comprend une combinaison d'accélérateurs comprenant 20% en poids ou plus, sur base du poids total des accélérateurs présents dans la composition, de composé(s) (a) de la formule générale (I).

**5.** Procédé suivant l'une quelconque des revendications 1 à 4, caractérisé en ce que la quantité totale d'accélérateurs présente dans la composition varie de 0,1% à 5,0% en poids, sur base du poids de la résine époxy.

**6.** Procédé suivant l'une quelconque des revendications 1 à 4, caractérisé en ce que la quantité totale de charge présente dans la composition varie de 50% à 90% en poids, sur base du poids total de la composition.

**7.** Procédé suivant l'une quelconque des revendications 1 à 6, caractérisé en ce qu'il comprend de la tris-(2,6-diméthoxyphényl)phosphine à titre d'accélérateur.